# EUROPÄISCHE PATENTSCHRIFT

(11) **EP 1 744 415 B1**
(45) Veröffentlichungstag und Bekanntmachung des Hinweises auf die Patenterteilung: **30.03.2011**
(21) Anmeldenummer: 06011753.8
(22) Anmeldetag: 07.06.2006
(51) Int. Cl.: H01S 5/022, H01L 33/00, H01S 5/024, H01S 5/00

(54) **Gehäuse für ein Laserdiodenbauelement und Laserdiodenbauelement**
Housing for a diode laser device and diode laser device
Boîtier pour dispositif à diode laser et dispositif à diode laser

(30) Priorität: 11.07.2005 DE 102005032305; 02.08.2005 DE 102005036266
(43) Veröffentlichungstag der Anmeldung: 17.01.2007
(73) Patentinhaber: OSRAM Opto Semiconductors GmbH, 93055 Regensburg (DE)
(72) Erfinder: Ferstl, Christian, 93073 Neutraubling (DE)
(74) Vertreter: Epping - Hermann - Fischer

(56) Entgegenhaltungen:
- EP-A- 1 309 048
- WO-A-2005/093853
- WO-A1-2004/001862
- WO-A2-2004/107511
- DE-A1- 19 944 042
- DE-A1-102004 051 362
- JP-A- 2002 109 774
- US-A1- 2003 156 608
- US-A1- 2004 136 001
- US-A1- 2005 023 538
- US-B1- 6 659 659

## Beschreibung

Die Erfindung betrifft ein Gehäuse für ein Laserdiodenbauelement sowie ein Laserdiodenbauelement mit einem derartigen Gehäuse. Zudem ist ein Verfahren zum Herstellen eines Laserdiodenbauelements angegeben.

Es sind Gehäuse für Laserdiodenbauelemente bekannt, bei denen gerade ausgebildete elektrische Anschlusspins derart an einem Gehäuseträger angebracht oder durch den Gehäuseträger hindurchgeführt sind, dass sie auf einer Außenseite des Gehäuses senkrecht von dem Gehäuseträger wegragen. Derartige Gehäuse sind insbesondere als Metallgehäuse ausgebildet. Sie weisen in der Regel eine Metall-Ummantelung auf, die den Zweck hat, den Laserdiodenchip oder Laserdiodenbarren vor äußeren Einflüssen zu schützen.

Metallgehäuse dieser Art sind für Laserdiodenbauelemente geeignet, die im cw-Modus ("continous wave modus") eine thermische Verlustleistung in der Größenordnung von 1 W aufweisen. Laserdiodenchips oder Laserdiodenbarren mit höheren Verlustleistungen, die beispielsweise in einem Bereich zwischen einschließlich 20 W und einschließlich 100 W liegen, werden meist in kostenaufwändigen speziellen Gehäusen eingebaut. Beispiele hierfür sind so genannte HHL-Gehäuse ("High Heat Load Packages") oder spezielle, für spezifische Anwendungen entworfene Gehäuse.

DE 199 44 042 A1 offenbart eine Beleuchtungseinheit mit einem mehrschichtigen Keramikträger an dem eine Ausnehmung vorgesehen ist, die über umlaufende Seitenwände seitlich geschlossen ist. In der Ausnehmung ist ein Laserdiodenarray mit einer Vielzahl separat adressierbarer und ansteuerbarer einzelner Laserdioden aufgenommen. Jede einzelne Laserdiode ist über einen eigenen Bonddraht mit einem pinartigen Anschlussmittel verbunden, wobei dieses pinartige Anschlussmittel in den mehrschichtigen Keramikträger eingebettet ist.

US 2004/0136001 A1 offenbart ein Metallgehäuse für eine Laserdiode mit elektrischen Durchführungen durch die Seitenwand des Gehäuses.

WO 2004/001862 A1 offenbart ein Halbleiterleuchtmittel mit einem Reflektor und einer Plastikverkapselung. Eine elektrische Zuleitung wird durch den Reflektor geführt und kann mit Hilfe eines Füllmaterials darin gehalten werden.

Es ist eine Aufgabe der vorliegenden Erfindung, ein kostengünstig herzustellendes und einfach zu handhabendes Gehäuse für ein Laserdiodenbauelement bereitzustellen, mit dem sich insbesondere ein Laserdiodenbauelement auf technisch einfache Weise mit hoher Präzision herstellen lässt.

Es wird ein Gehäuse gemäß Anspruch 1 angegeben, das für eine Oberflächenmontage ausgeführt ist und einen Träger umfasst, der auf einer Vorderseite einen Montagebereich für einen Laserdiodenchip oder Laserdiodenbarren aufweist, wobei das Gehäuse mindestens eine auf dem Träger angeordnete Haltevorrichtung umfasst, die (i) mindestens einen Durchbruch aufweist, in dem ein elektrischer Anschlussleiter gehalten ist, wobei ein Chipanschlussteil des Anschlussleiters vom Träger beabstandet ist und frei über die Vorderseite des Trägers ragt, (ii) ein metallisches und/oder keramisches Material aufweist, (iii) eine Reflektorschräge aufweist, die schräg zu einer Haupterstreckungsebene des Trägers verläuft, und (iv) als ein Rahmen für das Gehäuse ausgebildet ist.

Zudem wird gemäß Anspruch 23 ein Laserdiodenbauelement mit einem solchen Gehäuse angegeben, das mindestens einen Laserdiodenchip oder Laserdiodenbarren aufweist.

Weitere Ausführungsformen sind in den übrigen abhängigen Ansprüchen aufgeführt.

Unter einem Durchbruch ist vorliegend eine Öffnung oder eine Aussparung in der Haltevorrichtung zu verstehen. Der Durchbruch erstreckt sich insbesondere von einer Außenseite bis zu einer Innenseite der Haltevorrichtung. Die Innenseite der Haltevorrichtung ist einem Montagebereich für mindestens einen Laserdiodenchip oder Laserdiodenbarren zugewandt, die Außenseite ist von dem Montagebereich abgewandt. Unter dem Begriff "Träger" ist insbesondere ein Gehäuseträger oder ein tragender Grundkörper des Gehäuses zu verstehen.

Der elektrische Anschlussleiter ist bevorzugt durch den Durchbruch gesteckt und in diesem befestigt. Der Durchbruch weist hierzu mit Vorteil eine größere Querschnittsfläche auf als ein Teil des elektrischen Anschlussleiters, sodass dieser auf einfache Weise durch den Durchbruch durchgesteckt werden kann.

Mit Vorteil umfasst der elektrische Anschlussleiter einen breiten Teil und einen schmalen Teil, wobei der schmale Teil eine geringere Breite als der breite Teil aufweist. Der schmale Teil ist derart in dem Durchbruch gehalten, dass der breite Teil an der Außenseite der Haltevorrichtung angeordnet ist. Der breite Teil des elektrischen Anschlussleiters umfasst insbesondere einen Gehäuseanschlussteil, an dem das Gehäuse mittels einer Oberflächenmontage elektrisch leitend angeschlossen werden kann. Er weist bevorzugt eine streifenartige Form auf.

In einer zweckmäßigen Ausführungsform ist der elektrische Anschlussleiter mittels eines Füllmaterials in dem Durchbruch fixiert. Das Füllmaterial ist bevorzugt elektrisch isolierend, sodass die Haltevorrichtung beispielsweise auch dann elektrisch leitendes Material aufweisen oder aus einem solchen Material bestehen kann, wenn zwei oder mehrere elektrische Anschlussleiter an ihr oder in ihr gehalten sind. Durch die Verwendung des elektrisch isolierenden Füllmaterials kann die Gefahr eines Kurzschlusses deutlich verringert oder vermieden werden.

Der Träger weist in einer zweckmäßigen Ausführung auf einer Vorderseite einen Montagebereich für den Laserdiodenchip oder Laserdiodenbarren auf, wobei bevorzugt vorgesehen ist, dass diese unmittelbar auf dem Montagebereich montiert werden. Es ist jedoch auch möglich, den Laserdiodenchip oder den Laserdiodenbarren mittelbar, beispielsweise über eine entsprechende zusätzliche Halterung auf dem Montagebereich zu montieren.

Mit besonderem Vorteil sind der Träger und die Haltevorrichtung als separate Teile ausgebildet. Dies ermöglicht es beispielsweise, bei der Herstellung eines Laserdiodenbauelements zunächst einen Laserdiodenchip oder Laserdiodenbarren auf dem Träger zu montieren und nachfolgend die Haltevorrichtung mit dem elektrischen Anschlussleiter auf dem Träger anzuordnen. Die Haltevorrichtung kann hierzu zum Beispiel aufgesetzt werden.

Besonders bevorzugt weist das Gehäuse mindestens zwei elektrische Anschlussleiter auf, die jeweils mittels der Haltevorrichtung gehalten sind. Die elektrischen Anschlussleiter sind insbesondere jeweils in einem Durchbruch der mindestens einen Haltevorrichtung gehalten.

Das Gehäuse weist gemäß einer besonders zweckmäßigen Ausführungsform einen einfachen Aufbau auf, bei dem der Träger mit besonderem Vorteil frei von elektrischen Anschlussleitern ist. Erfindungsgemäß ist der elektrische Anschlussleiter oder sind die elektrischen Anschlussleiter vom Träger beabstandet. Erfindungsgemäß ragt der oder ragen die Anschlussleiter frei über der Vorderseite des Trägers.

Gemäß einer vorteilhaften Ausführungsform ist ein Bauelementanschlussteil des elektrischen Anschlussleiters lateral vom Träger beabstandet. Unter "lateral" sind in diesem Zusammenhang Richtungen zu verstehen, die parallel zu einer Haupterstreckungsebene des Trägers verlaufen. Durch diese Maßnahme ist das Gehäuse frei von dem Bauelementanschlussteil und kann beispielsweise ausschließlich zum thermischen Anschließen verwendet werden.

Der elektrische Anschlussleiter ist mit besonderem Vorteil gegenüber zumindest eines Teils des Trägers elektrisch isoliert. Dies gilt mit besonderem Vorteil für mindestens zwei elektrische Anschlussleiter des Gehäuses.

Sowohl die Haltevorrichtung als auch der Träger sind für die Verwendung einer Vielzahl verschiedener Materialien geeignet.

Erfindungsgemäß weist die Haltevorrichtung ein metallisches und/oder keramisches Material auf. Zusätzlich oder alternativ weist der Träger metallisches und/oder keramisches Material auf.

Derartige Materialien haben den Vorteil, resistent gegenüber hohen Temperaturen zu sein, die beispielsweise bei Lötvorgängen auftreten können. Bevorzugt weisen verwendete keramische und/oder metallische Materialien eine hohe Wärmeleitfähigkeit auf. Gemäß einer zweckmäßigen Ausführungsform ist das Gehäuse für Umgebungstemperaturen bis zu 125° C ausgeführt. Besonders bevorzugt ist das Gehäuse frei von Kunststoff.

Gemäß einer weiteren vorteilhaften Ausführungsform ist der Träger als ein Wärmeabfuhrelement ausgebildet, zum Abführen von Wärme, die bei Betrieb eines im Gehäuse zu montierenden Laserdiodenchips oder Laserdiodenbarrens entsteht. Mit besonderem Vorteil weist eine der Vorderseite gegenüberliegende Rückseite des Trägers eine thermische Anschlussfläche auf. Insbesondere kann die gesamte rückseitige Fläche des Trägers als eine thermische Anschlussfläche verwendet werden. Die Rückseite des Trägers ist die von einem Montagebereich für den Laserdiodenchip oder Laserdiodenbarren abgewandte Seite.

Besonders bevorzugt ist die thermische Anschlussfläche gegenüber elektrischen Anschlussleitern des Gehäuses elektrisch isoliert. Dadurch kann eine elektrische und räumliche Trennung von Wärmeabfuhr und elektrischer Kontaktierung im Gehäuse oder im Bauelement erzielt werden, was für das elektrische und thermische Anschließen des Gehäuses oder des Bauelements vorteilhaft sein kann.

Beispielsweise kann dass Bauelement somit thermisch an Flächen angeschlossen, unabhängig davon, auf welchem elektrischen Potential sich diese Flächen befinden.

Die Haltevorrichtung besteht bevorzugt im Wesentlichen aus metallischem Material. Gemäß dieser Ausführungsform besteht die Haltevorrichtung wenigstens zu einem Großteil, das heißt zu mindestens 50 % aus metallischem Material. Metallisches Material hat den Vorteil, nicht nur hitzebeständig sondern auch mechanisch stabil zu sein. Zudem ist es möglich, einen gewünschten thermischen Ausdehnungskoeffizienten für die Haltevorrichtung durch die Bildung und Verwendung spezieller Legierungen einzustellen. Bevorzugt ist der thermische Ausdehnungskoeffizient möglichst gering.

Die Haltevorrichtung weist mit Vorteil mindestens eines der Materialien Nickel, Eisen und Kobalt auf. Besonders bevorzugt ist eine Legierung vorgesehen, die mindestens zwei dieser Materialien aufweist. Mit derartigen Legierungen sind besonders geringe thermische Ausdehnungskoeffizienten erzielbar.

Es wird weiterhin ein Gehäuse angegeben, bei dem die Haltevorrichtung mit einer Beschichtung versehen ist, die geeignet ist, elektromagnetische Strahlung zu reflektieren. Somit kann die Haltevorrichtung vorteilhafterweise zusätzlich als ein Reflektor fungieren. Bevorzugt weist die Beschichtung metallisches Material auf oder besteht aus metallischem Material. Zusätzlich oder alternativ weist die Beschichtung eine Schichtenfolge für einen Bragg-Spiegel auf.

Gemäß der Erfindung weist die Haltevorrichtung eine Reflektorschräge auf, die schräg zu einer Haupterstreckungsebene des Trägers verläuft. Die Reflektorschräge ist insbesondere für eine Verwendung von kantenemittierenden Laserdioden vorteilhaft, deren elektromagnetische Strahlung innerhalb des Gehäuses mittels der Reflektorschräge in eine Abstrahlrichtung umgelenkt werden kann.

Die Reflektorschräge ist bevorzugt in die Haltevorrichtung eingeprägt. Dies ist beispielsweise möglich, wenn die Haltevorrichtung zumindest in dem für die Reflektorschräge vorgesehenen Teil aus metallischem Material besteht. Die Reflektorschräge ist mit Vorteil zusätzlich oder alternativ mit reflektierendem Material versehen. Auf das Einbringen eines separaten Umlenkelements in das Gehäuse kann mit Vorteil verzichtet werden.

Gemäß einer zweckmäßigen Ausführungsform ist die Reflektorschräge mit reflektierendem Material in Form eines Reflektorplättchens versehen. Das Reflektorplättchen ist insbesondere eben ausgebildet. Durch die Verwendung eines Reflektorplättchens kann ein besonders hochwertiger Reflektor auf technisch einfache Weise auf der Reflektorschräge ausgebildet werden.

Die Reflektorschräge weist in einer vorteilhaften Ausführungsform eine konkave Krümmung auf. Durch eine derartige konkave Krümmung kann die Reflektorschräge nicht nur zum bloßen Umlenken von elektromagnetischer Strahlung, sondern beispielsweise zusätzlich zum Fokussieren und/oder Homogenisieren eines Strahlenbündels dienen. Die Krümmung kann insbesondere auch eingeprägt sein.

Der Träger weist mit Vorteil eine erste Trägerschicht mit einem Montagebereich für einen Laserdiodenchip oder einen Laserdiodenbarren auf, die auf einer von dem Montagebereich abgewandten Seite mittels eines Hartlotes mit einer zweiten Trägerschicht des Trägers verbunden ist. Die zweite Trägerschicht weist besonders bevorzugt ein metallisches Material auf oder besteht aus einem solchen.

Zusätzlich oder alternativ weist der Träger mit besonderem Vorteil zwei Trägerschichten mit metallischem Material und eine zwischen diesen Trägerschichten angeordnete Trägerschicht mit keramischem Material auf. Eine dieser Trägerschichten mit metallischem Material kann insbesondere die oben genannte zweite Trägerschicht bilden.

Erfindungsgemäß ist die Haltevorrichtung als ein Rahmen für das Gehäuse ausgebildet. Dadurch kann eine zu montierende Laserdiode vor äußeren Einflüssen geschützt werden.

Insgesamt ist es mit den hier vorgestellten Konzepten möglich, dass die Haltevorrichtung in einem Gehäuse drei Funktionen gleichzeitig erfüllt. Eine Funktion ist, mindestens einen elektrischen Anschlussleiter zu halten. Eine weitere Funktion ist, einen Rahmen für das Gehäuse zu bilden. Schließlich erfüllt die Haltevorrichtung die Funktion einer Strahlenumlenkung oder eines Spiegels. Durch das Integrieren mehrerer Funktionen in ein einziges Element kann der Aufbau und die Herstellung des Gehäuses verglichen mit herkömmlichen Gehäusen vereinfacht werden.

Das Gehäuse ist mit Vorteil für ein Laserdiodenbauelement mit einer thermischen Verlustleistung von größer als oder gleich 3 W, bevorzugt von größer als oder gleich 5 W ausgeführt oder geeignet. Besonders bevorzugt ist das das Gehäuse für ein Laserdiodenbauelement mit einer thermischen Verlustleistung von größer als oder gleich 6 W ausgeführt oder geeignet. Dies ist bei dem Gehäuse insbesondere durch dessen einfachen Aufbau mit Träger und Haltevorrichtung möglich. Der einfache Aufbau erlaubt es insbesondere, den Träger hinsichtlich einer guten Wärmeabfuhr in einem höheren Maße zu optimieren, als das bei einer Vielzahl herkömmlicher Gehäuse für Laserdiodenbauelemente der Fall ist.

Es wird ein Laserdiodenbauelement angegeben, welches das Gehäuse sowie mindestens einen Laserdiodenchip oder Laserdiodenbarren aufweist. Wie vorhergehend bereits beschrieben, kann der Laserdiodenchip oder der Laserdiodenbarren unmittelbar oder mittelbar auf den Träger montiert sein. Für eine mittelbare Montage kann beispielsweise ein Halteelement verwendet werden, an dem die Laserdiode beispielsweise auch derart montiert sein kann, dass sich ihre Haupterstreckungsebene senkrecht zu einer Haupterstreckungsebene des Trägers erstreckt. Bevorzugt ist die Laserdiode jedoch derart montiert, dass ihre Haupterstreckungsebene parallel zu einer Haupterstreckungsebene des Trägers verläuft.

Bevorzugt weist das Laserdiodenbauelement mindestens einen kantenemittierenden Laserdiodenchip oder Laserdiodenbarren auf, das heißt die Laserdiode emittiert, bezogen auf ihre Haupterstreckungsebene, im wesentlichen horizontal.

Mit besonderem Vorteil weist das Laserdiodenbauelement eine thermische Verlustleistung von größer als oder gleich 3 W, bevorzugt von größer als oder gleich 5 W und besonders bevorzugt von größer als oder gleich 6 W auf. Alle Angaben von thermischen Verlustleistungen gelten insbesondere für den Fall, dass das Laserdiodenbauelement im CW-Modus ("Continuous Wave Modus") betrieben wird.

In einer zweckmäßigen Ausführungsform ist auf der Haltevorrichtung des Laserdiodenbauelements ein Abdeckkörper aufgebracht. Dieser weist vorzugsweise zumindest ein strahlungsdurchlässiges Fenster auf. Bevorzugt ist der Abdeckkörper als ein optisches Element ausgebildet. Alternativ ist ein optisches Element auf dem Abdeckkörper angeordnet. Durch den einfachen Aufbau des Gehäuses lässt sich der Abdeckkörper und ein etwaiges damit verbundenes optisches Element besonders präzise relativ zu der Laserdiode justieren.

Das optische Element weist in einer zweckmäßigen Ausführungsform mindestens eine Linse auf.

Gemäß einer besonders vorteilhaften Ausführungsform weist das optische Element mehrere Strukturelemente auf. Die Strukturelemente enthalten bevorzugt Mikrolinsen, Linienstrukturen, Strukturen in der Art wie für eine Fresnell-Linse und/oder Aufrauungen. Unter Linienstrukturen sind Strukturen mit einer lang gestreckten, linienartigen Form zu verstehen. Unter Strukturen in der Art wie für eine Fresnell-Linse fallen insbesondere auch Strukturen einer Fresnell-Linse selbst, wobei das Merkmal auch Abwandlungen derartiger Strukturen umfasst. Derartige Abwandlungen können sich insbesondere bei Kombinationen unterschiedlicher Strukturelemente miteinander ergeben.

Das optische Element mit den Strukturelementen ist insbesondere geeignet, den zu emittierenden Laserstrahl zu homogenisieren. Besonders kantenemittierende Laser emittieren oftmals einen Laserstrahl mit einem stark anisotropen Strahlquerschnitt, der häufig eine elliptische Form aufweist. In einer bevorzugten Ausführungsform ist das optische Element dazu geeignet, die Anisotropie des Strahlensquerschnitts signifikant zu verringern. Homogenisieren heißt, eine räumlich gleichmäßigere Verteilung der Strahlungsintensität des emittierten Laserstrahles zu bewirken.

Gemäß einer besonders vorteilhaften Ausführungsform weist der Abdeckkörper zusätzlich oder alternativ einen Bragg-Spiegel auf. Mit dem Bragg-Spiegel kann elektromagnetische Strahlung eines gewünschten, engen Frequenzbereichs selektiv reflektiert werden. Der Bragg-Spiegel kann einen externen Resonatorspiegel für den Laserdiodenchip oder Laserdiodenbarren bilden, mittels dem ein gewünschter zu emittierender Frequenzbereich des Laserdiodenchips eingestellt werden kann. Durch einen derartigen externen Resonatorspiegel können zum Beispiel Temperatureinflüsse auf das Laserdiodenbauelement zumindest teilweise kompensiert werden.

In einer besonders zweckmäßigen Ausführungsform ist auf dem Träger und in einem Strahlengang des Laserdiodenchips oder Laserdiodenbarrens eine Optik angeordnet. Dadurch kann bereits in der Nähe des Laserdiodenchips oder Laserdiodenbarrens Einfluss auf die Eigenschaften des zu emittierenden Laserstrahles genommen werden.

Bei einem nicht zur Erfindung gehörenden Verfahren wird ein Träger bereitgestellt und ein Laserdiodenchip oder Laserdiodenbarren unmittelbar oder mittelbar auf den Träger montiert. Das herzustellende Laserdiodenbauelement ist für eine Oberflächenmontage ausgeführt.

Es handelt sich somit um ein oberflächenmontierbares Bauelement, das auch als SMD-Bauelement bezeichnet werden kann (SMD = "Surface Mountable Device"). In diesem Zusammenhang wird auch von Oberflächenmontage-Technologie (SMT, "Surface Mounting Technology") gesprochen.

Gemäß einer Ausführungsform des Verfahrens wird mindestens eine Haltevorrichtung bereitgestellt, mindestens ein Durchbruch in der Haltevorrichtung ausgebildet und wird ein elektrischer Anschlussleiter in dem Durchbruch befestig. Zudem beinhaltet diese Ausführungsform des Verfahrens ein Aufsetzen der Haltevorrichtung auf den Träger.

Eine weitere vorteilhafte Ausführungsform des Verfahrens sieht vor, dass der Träger gemeinsam mit einer auf einer Vorderseite des Trägers angeordneten Haltevorrichtung bereitgestellt wird. Bei diesem Verfahren können Träger und Haltevorrichtung insbesondere auch einstückig miteinander ausgebildet sein. In der Haltevorrichtung wird mindestens ein Durchbruch ausgebildet. Mit Vorteil wird der elektrische Anschlussleiter erst nach einer Montage eines Laserdiodenchips oder Laserdiodenbarrens auf dem Träger an der Haltevorrichtung befestigt.

Die einzelnen Verfahrensschritte können grundsätzlich, soweit physikalisch möglich, in beliebiger Reihenfolge durchgeführt werden. Die Reihenfolge, in der einzelne Verfahrensschritte im Rahmen dieser Anmeldung wiedergegeben werden, geben grundsätzlich nicht wieder, in welcher Reihenfolge die einzelnen Verfahrensschritte durchzuführen sind. Dies gilt insbesondere für die in den Patentansprüchen enthaltenen Angaben.

Mit besonderem Vorteil wird bei dem Verfahren eine Reflektorschräge in die Haltevorrichtung eingebracht. Durch einen derartigen Verfahrensschritt kann beispielsweise das Bereitstellen und Montieren eines separaten Umlenkelementes ersetzt werden.

Der Träger wird bevorzugt in einem Verbund mit einer Vielzahl weiterer Träger bereitgestellt. Mit besonderem Vorteil erfolgt die Montage der Laserdiode auf den Träger "im Nutzen", das heißt in einem Verfahrensstadium, in dem sich die Träger noch im gemeinsamen Verbund befinden. Besonders bevorzugt wird auch die Haltevorrichtung vor dem Vereinzeln der Träger aus ihrem Verbund aufgebracht.

Eine derartige Bestückung des Trägers ist mit Vorteil besonders kostengünstig. Zudem verschafft es die Möglichkeit einer besonders präzisen Anordnung des Chips oder des Barrens auf dem Träger, da dieser beim Bestücken frei von der Haltevorrichtung und dem elektrischen Anschlussleiter und somit besonders gut zugänglich ist.

Besonders bevorzugt wird bei dem Verfahren eine Mehrzahl gleicher oder gleichartiger Leuchtdiodenbauelemente im Wesentlichen gleichzeitig hergestellt. Hierfür eignet sich insbesondere die Verwendung von Trägern, die in einem gemeinsamen Verbund bereitgestellt werden. Diese Träger werden bevorzugt erst nach der Fertigstellung der Mehrzahl von Laserdiodenbauelementen voneinander getrennt.

Mit besonderem Vorteil wird vor dem Vereinzeln der Träger ein Testbetrieb der Laserdiodenbauelemente zum Ermitteln und Rausfiltern von Frühausfällen unter den Bauelementen durchgeführt. Durch den gemeinsamen Verbund lassen sich mehrere Laserdiodenbauelemente hierfür auf technisch einfache Weise gemeinsam in Position bringen und elektrisch leitend anschließen.

Bei einer zweckmäßigen Ausführungsform des Verfahrens wird ein Abdeckkörper auf der Haltevorrichtung aufgebracht.

Bei dem Verfahren wird der Träger bevorzugt in zwei separaten Teilen bereitgestellt, von denen ein erster Teil auf mindestens einer ersten Seite mit einer ersten Hartlotschicht versehen ist und mit dieser ersten Hartlotschicht auf einen zweiten Teil des Trägers gelegt und durch Wärmezufuhr mit dem zweiten Teil verbunden wird. Besonders bevorzugt ist der erste Teil des Trägers auf einer der ersten Seite gegenüberliegenden zweiten Seite mit einer zweiten Hartlotschicht versehen. Die Montage des Laserdiodenchips oder Laserdiodenbarrens umfasst hierbei, diesen auf die zweite Hartlotschicht zu legen und durch Wärmezufuhr mit dem ersten Teil des Trägers zu verbinden.

Durch dieses Verfahren ist es insbesondere mit Vorteil möglich, das Verbinden des ersten Teils mit dem zweiten Teil und die Montage des Laserdiodenchips oder Laserdiodenbarrens gleichzeitig durchzuführen. Dies ist auf technisch einfache Weise durchführbar und zudem einer kostengünstigen Herstellung des Laserdiodenbauelements zuträglich. Allgemein ausgedrückt werden Teile des Trägers untereinander und ein Laserdiodenchip oder Laserdiodenbarren mit dem Träger im Wesentlichen gleichzeitig durch einen Stack-Lötprozess miteinander verbunden.

Weitere Vorteile, bevorzugte Ausführungsformen und Weiterbildungen des Gehäuses, des Laserdiodenbauelements, sowie des nicht zur Erfindung gehörenden Verfahrens ergeben sich aus den im folgenden in Verbindung mit den Figuren 1 bis 7d erläuterten Ausführungsbeispielen.

Es zeigen:
- Figur 1: eine schematische perspektivische Darstellung des Laserdiodenbauelements mit dem Gehäuse gemäß eines ersten Ausführungsbeispiels,
- Figur 2: eine schematische Schnittansicht des in Figur 1 dargestellten Laserdiodenbauelements,
- Figur 3: eine schematische Draufsicht auf ein Laserdiodenbauelement mit Gehäuse gemäß eines zweiten Ausführungsbeispiels,
- Figur 4: eine schematische Schnittansicht des in Figur 3 dargestellten Laserdiodenbauelements,
- Figur 5: eine schematische perspektivische Darstellung des in den Figuren 3 und 4 dargestellten Laserdiodenbauelements,
- Figur 6: eine schematische perspektivische Darstellung eines Laserdiodenbauelements gemäß eines dritten Ausführungsbeispiels,
- Figuren: 7a bis 7d eine schematische Draufsicht auf eine Mehrzahl sich im gemeinsamen Verbund befindlichen Träger während verschiedenen Verfahrensstadien eines Ausführungsbeispiels des Verfahrens,
- Figur 8: eine schematische perspektivische Darstellung einer Abdeckplatte für ein Laserdiodenbauelement mit einem optischen Element gemäß eines zweiten Ausführungsbeispiels,
- Figur 9: eine schematische perspektivische Darstellung einer Abdeckplatte für ein Laserdiodenbauelement mit einem optischen Element gemäß eines dritten Ausführungsbeispiels,
- Figur 10: eine schematische perspektivische Darstellung einer Abdeckplatte für ein Laserdiodenbauelement mit einem optischen Element gemäß eines vierten Ausführungsbeispiels,
- Figur 11: eine schematische perspektivische Darstellung einer Abdeckplatte für ein Laserdiodenbauelement mit einem optischen Element gemäß eines fünften Ausführungsbeispiels,
- Figur 12: eine schematische Schnittansicht eines Laserdiodenbauelements gemäß eines dritten Ausführungsbeispiels,
- Figur 13: eine schematische Schnittansicht einer Haltevorrichtung für ein Laserdiodenbauelement gemäß eines vierten Ausführungsbeispiels, und
- Figuren 14 und 15: schematische Schnittansichten verschiedener Verfahrensstadien eines zweiten Ausführungsbeispiels des Verfahrens.

In den Ausführungsbeispielen und Figuren sind gleiche oder gleichwirkende Bestandteile jeweils mit den gleichen Bezugszeichen versehen. Die dargestellten Bestandteile sowie die Größenverhältnisse der Bestandteile untereinander sind nicht notwendigerweise als maßstabsgerecht anzusehen. Vielmehr können einige Details der Figuren zum besseren Verständnis übertrieben groß dargestellt sein.

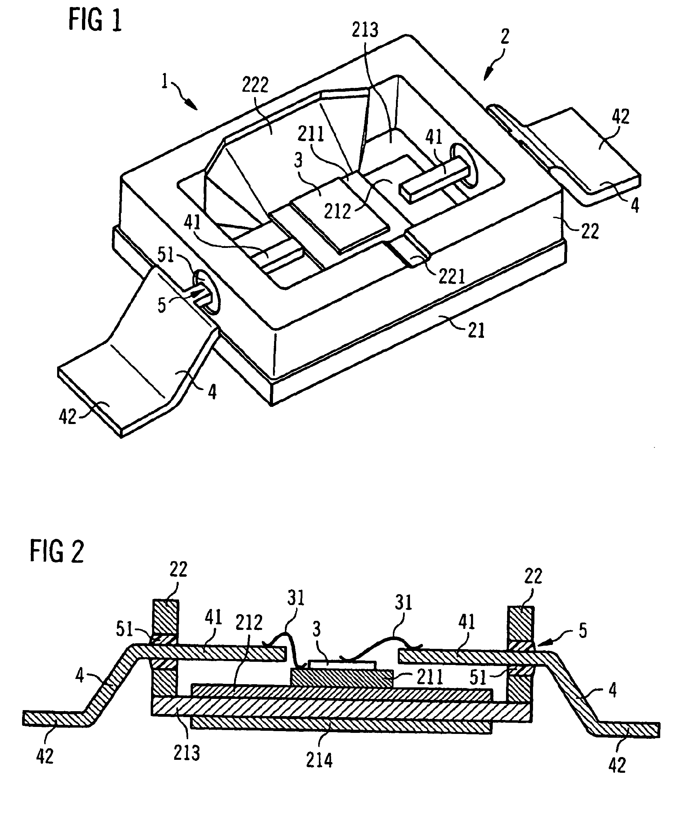

Das in Figur 1 dargestellte Laserdiodenbauelement 1 ist ein Lasermodul. Es umfasst ein Gehäuse 2 mit einem Träger 21 und einer Haltevorrichtung 22.

Die Haltevorrichtung 22 ist als ein Rahmen für das Gehäuse 2 ausgebildet. Sie weist an zwei einander gegenüber liegenden Seiten jeweils einen Durchbruch 5 auf. Der Durchbruch 5 ist in Form einer Öffnung, beispielsweise einer Durchbohrung ausgebildet. Er erstreckt sich von einer Außenseite bis zu einer Innenseite der Haltevorrichtung. Die rahmenartig ausgebildete Haltevorrichtung umschließt einen mittleren Bereich der Vorderseite des Trägers 21 derart, dass eine Kavität gebildet ist. In dieser Kavität ist z.B. ein Lumineszenzdiodenchip 3 angeordnet.

In die Durchbrüche 5 sind jeweils elektrische Anschlussleiter 4 gesteckt. Sie sind mittels einer Füllmasse 51 in den Durchbrüchen fixiert. Die Füllmasse weist beispielsweise Glas auf oder besteht aus diesem. Das Glas, beispielsweise auf der Basis von Siliziumdioxid, ist elektrisch isolierend, so dass die elektrischen Anschlussleiter 4 gegenüber der Haltevorrichtung 22 elektrisch isoliert sind. Dadurch kann die Haltevorrichtung 22 ein elektrisch leitfähiges Material aufweisen oder aus einem solchen bestehen, ohne dass notwendigerweise die Gefahr eines Kurzschlusses zwischen den Anschlussleitern 4 besteht.

Beispielsweise besteht die Haltevorrichtung 22 aus einem metallischen Material wie etwa einer Legierung, die Kobalt, Nickel und Eisen aufweist. Besonders geeignet ist eine Legierung mit einer Zusammensetzung aus 17 % Kobalt, 29 % Nickel und 54 % Eisen. Diese Legierung weist einen geringen Wärmeausdehnungskoeffizienten auf und ist insbesondere für Glas-Metall-Verbindungen geeignet. Alternativ kann eine Legierung verwendet werden, die Nickel und Eisen aufweist. Sie weist beispielsweise eine Zusammensetzung aus 42 % Nickel und 58 % Eisen auf.

Zusätzlich oder alternativ kann die Haltevorrichtung 22 auch ein keramisches Material wie beispielsweise Aluminiumnitrid aufweisen oder aus einem solchen Material bestehen.

Die elektrischen Anschlussleiter weisen jeweils einen schmalen Bereich 41 und einen breiten Bereich 42 auf. Sie sind mit dem schmalen Bereich in die Durchbrüche 5 gesteckt, so dass der breite Bereich jeweils auf der Außenseite, das heißt außerhalb der rahmenartig ausgebildeten Haltevorrichtung 22, angeordnet ist.

Der schmale Bereich 41 ragt teilweise ins Innere des Gehäuses. Er ist, genauso wie der gesamte elektrische Anschlussleiter 4, vom Träger beabstandet und ragt frei über der Vorderseite des Trägers, das heißt zwischen der Vorderseite des Trägers 21 und dem darüber ragenden Teil des schmalen Bereiches 41 gibt es einen Zwischenraum, der frei von fester Materie ist.

Die elektrischen Anschlussleiter 4 sind in dem in Figur 1 dargestellten Ausführungsbeispiel ausschließlich durch das Halteelement 22 gehalten. Somit sind sie bei Verwendung einer elektrisch isolierenden Füllmasse 51 nicht nur gegenüber dem Halteelement 22, sondern grundsätzlich auch gegenüber dem Träger 21 elektrisch isoliert. Eine elektrisch leitfähige Verbindung eines Anschlussleiters zu einem elektrisch leitfähigen Teil des Trägers ist in dem Laserdiodenbauelement 1 beispielsweise über einen Bonddraht 31 ausgebildet.

Derjenige Teil des schmalen Bereiches 41 der elektrischen Anschlussleiter 4, der in das Innere des Gehäuses hineinragt, bildet einen Chipanschlussbereich, über den eine Laserdiode im Inneren des Gehäuses elektrisch leitend angeschlossen werden kann. Die breiten Bereiche 42 sind beispielsweise vom Träger 21 und von der Haltevorrichtung 22 lateral beabstandet.

Die breiten Bereiche 42 sind zum Beispiel jeweils derart gebogen, dass sich ihr äußerer Teil im wesentlichen in einer gleichen Ebene wie die Rückseite des Trägers erstreckt, so dass das Bauelement oberflächenmontierbar ausgeführt ist. Oberflächenmontierbar heißt, dass das Bauelement auf einer geeigneten Oberfläche elektrisch und mechanisch montiert werden kann, ohne dass beispielsweise eine aufwendige Steckmontage notwendig wäre.

Ein beispielhafter Aufbau des Trägers 21 lässt sich besonders gut aus der in Figur 2 dargestellten Schnittansicht ersehen. In dem dort dargestellten Beispiel weist der Träger im wesentlichen vier Trägerplatten oder Trägerschichten 211, 212, 213, 214 auf. Er umfasst beispielsweise ein DCB-Substrat (Direct Copper Bonding-Substrat). Statt einem mehrschichtigen Aufbau kann der Träger jedoch zum Beispiel auch nur eine einzige Schicht oder Platte aufweisen, die beispielsweise aus keramischem Material wie Aluminiumnitrid oder aus einem metallischen Werkstoff besteht. Aluminiumnitrid ist aufgrund seiner geringen Beschaffungskosten und seiner hohen Wärmeleitfähigkeit von Vorteil. Alternativ kann der Träger zum Beispiel auch Silizium oder Siliziumcarbid aufweisen.

Der in Figur 2 dargestellte Träger weist beispielsweise eine dritte Trägerschicht 213 aus keramischem Material wie Aluminiumnitrid auf. Die Vorderseite und Rückseite der ersten Trägerschicht 213 ist mit einer zweiten und einer vierten Trägerschicht 212, 214 versehen, die beispielsweise ein metallisches Material wie Kupfer aufweisen oder aus einem solchen Material bestehen.

Auf der zweiten Trägerschicht 212, die auf der Vorderseite der ersten Trägerschicht 213 angeordnet ist, ist zum Beispiel eine erste Trägerschicht 211 angeordnet, die als ein Submount dient. Die erste Trägerschicht 211 besteht beispielsweise aus einem elektrisch isolierenden Material wie Aluminiumnitrid und ist auf ihrer Vorderseite mit einer Metallschicht versehen, die zum Beispiel Gold und/oder Zinn aufweist. Die Metallschicht bildet einen Montagebereich in Form einer Montagefläche, beispielsweise für einen Laserdiodenchip 3.

Es ist auch möglich, den Träger 21 ohne die erste Trägerschicht 211 auszubilden und den Laserdiodenchip 3 beispielsweise unmittelbar auf der darunter liegenden zweiten Trägerschicht 212 zu montieren.

Als weitere Alternative ist es auch möglich, dass der Träger eine einzige Metallplatte aufweist. Als metallische Materialien kommen die gleichen in Frage, die vorhergehend im Zusammenhang mit der Haltevorrichtung 22 angegeben worden sind.

Der Laserdiodenchip 3 ist beispielsweise mittels zweier Bonddrähte 31 elektrisch leitend mit den Anschlussleitern 4 verbunden, wobei die Vorderseite des Laserdiodenchips 3 unmittelbar mittels des Bonddrahtes kontaktiert ist und die Rückseite elektrisch leitend mit der auf der ersten Trägerschicht 211 aufgebrachten Metallbeschichtung verbunden ist, die wiederum mittels eines Bonddrahtes elektrisch leitend mit dem zweiten Anschlussleiter verbunden ist.

Durch die Ausführung des Gehäuses 2 beziehungsweise des Laserdiodenbauelements 1 lässt sich dieses in ein und derselben Ebene sowohl elektrisch als auch thermisch anschließen. Der thermische Anschluss des Gehäuses 2 ist beispielsweise durch die Rückseite des Trägers 21 gebildet, was mit Bezug auf die in Figur 2 dargestellte Schnittansicht im wesentlichen die Rückseite der untersten Schicht 214 wäre.

Da die Bauelementanschlussteile der elektrischen Anschlussleiter 4 jeweils lateral vom Träger 21 beabstandet sind, erfolgt der elektrische und der thermische Anschluss unabhängig voneinander, was unter anderem für eine Montierbarkeit des thermischen Anschlusses von Vorteil ist.

Wie in Figur 1 dargestellt, weist die Haltevorrichtung 22 eine Reflektorschräge 222 auf. Die Reflektorschräge 222 oder die gesamte Haltevorrichtung 22 sind beispielsweise mit einer gut reflektierenden Schicht versehen, zum Beispiel mit einer Goldschicht. Dadurch kann die Reflektorschräge 222 als Umlenkelement im Bauelementgehäuse dienen, so dass das Bauelement insbesondere auch für kantenemittierende Laserdioden geeignet ist, die derart in das Gehäuse montiert werden, dass ihre aktive Zone im wesentlichen parallel zu einer Haupterstreckungsebene des Trägers ausgerichtet ist.

Die Reflektorschräge 222 ist beispielsweise in die Haltevorrichtung 22 eingeprägt. Dies ist insbesondere möglich, wenn zumindest ein entsprechender Teil der Haltevorrichtung 22 aus metallischem Material besteht. Das Einbringen einer Reflektorschräge in die Haltevorrichtung 22 ist jedoch grundsätzlich auch bei Verwendung anderer Materialien wie zum Beispiel keramischem Material möglich.

Die Haltevorrichtung 22 weist neben den zwei Durchbrüchen 5 zusätzlich noch einen Lüftungsdurchbruch 221 in Form einer Aussparung auf einer vom Träger 21 abgewandten Seite der Haltevorrichtung auf. Der Lüftungsdurchbruch 221 ist geeignet, für einen Druck-, Temperatur- und Luftfeuchtigkeitsausgleich zu sorgen, falls das Gehäuse 2 auf seiner Vorderseite vollständig mittels eines Abdeckkörpers abgedeckt würde.

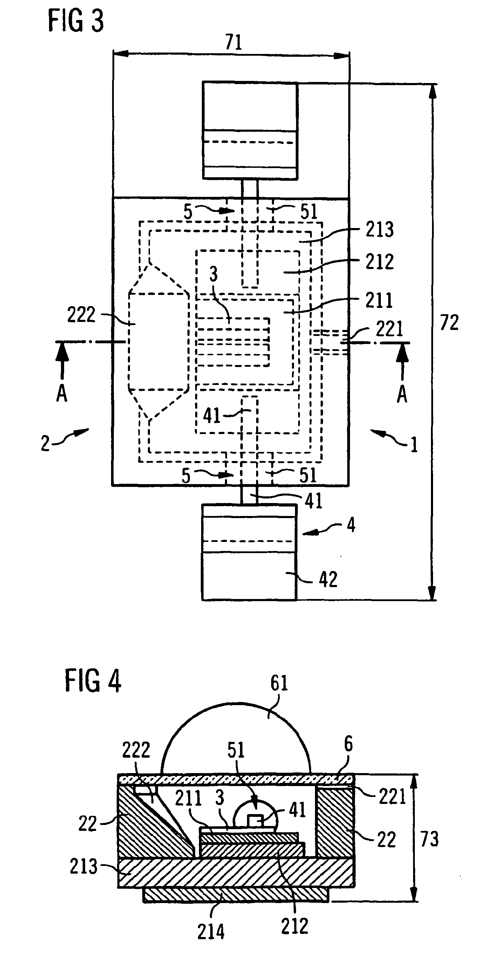

Ein Laserdiodebauelement 1 mit einem derartigen Abdeckkörper ist in den Figuren 3 bis 5 dargestellt. Dieses weist eine Abdeckplatte 6 mit einer Linse 61 auf. Abdeckplatte 6 und Linse 61 können beispielsweise aus demselben Material bestehen, beispielsweise aus einem Glas das auf Siliziumdioxid basiert oder aus diesem besteht. Sie können zudem einstückig miteinander ausgebildet sein. Alternativ ist es möglich, dass sie als separate Teile ausgeführt sind und dass die Linse 61 auf der Abdeckplatte 6 aufgesetzt ist.

Im übrigen ist das in den Figuren 3 bis 5 dargestellte Laserdiodenbauelement ähnlich wie in dem vorhergehend anhand der Figuren 1 und 2 erläuterten Ausführungsbeispiel ausgeführt. Es kann insbesondere dieselben Materialien aufweisen.

In dem Gehäuse 2 ist ein kantenemittierender Laserdiodenbarren 3 montiert. Es kommen beispielsweise Laserdioden in Frage, die im Infraroten emittieren. Diese weisen beispielsweise eine epitaktische Halbleiterschichtenfolge mit einer elektromagnetische Strahlung emittierenden aktiven Zone auf der Basis von Galliumarsenid (GaAs) oder Aluminiumgalliumarsenid (AlGaAs) auf. Es ist auch möglich, Laserdioden auf der Basis von InAlGaN zu verwenden, die beispielsweise blaues Licht und/oder elektromagnetische Strahlung aus dem ultravioletten Bereich emittieren. Mögliche Ausführungsformen sowie die Herstellung geeigneter Laserdioden sind dem Fachmann bekannt.

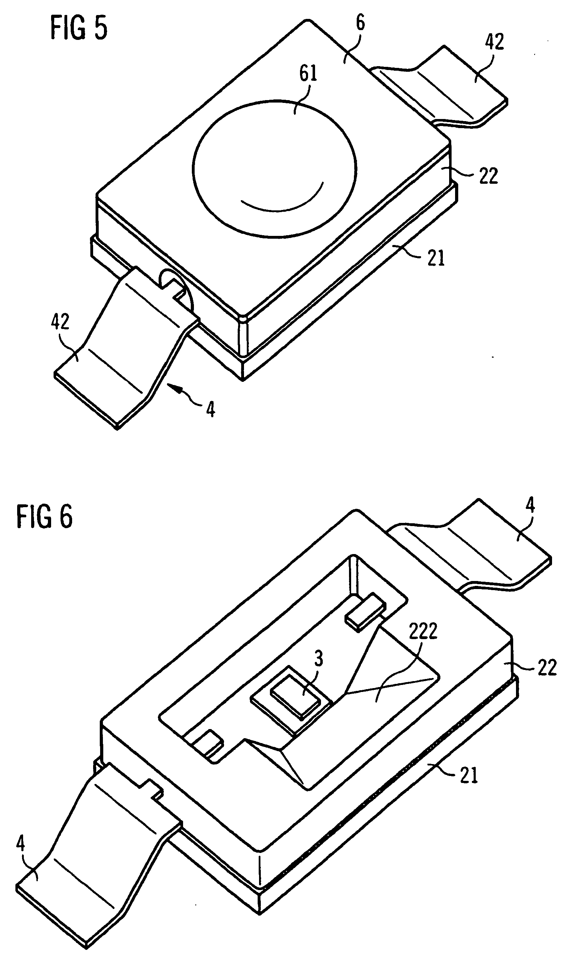

Das Laserdiodenbauelement 1 weist eine Länge 72 zwischen einschließlich 8 mm und einschließlich 13 mm auf, zum Beispiel beträgt die Länge 10,5 mm. Die Länge des Trägers 21 beträgt beispielsweise 6 mm. Die Breite 71 des Laserdiodenbauelements umfasst zwischen einschließlich 3 und einschließlich 6 mm, beispielsweise 4,5 mm. Die Höhe 73 des Laserdiodenbauelements beträgt beispielsweise zwischen einschließlich 2 mm und einschließlich 4 mm, beispielsweise 2,5 mm, wobei die in den Figuren 4 und 6 dargestellte Linse 61 nicht berücksichtigt ist.

Das in Figur 6 dargestellte Laserdiodenbauelement ist ähnlich den vorhergehend beschriebenen Ausführungsbeispielen gestaltet. Ein Unterschied zu den vorhergehend anhand der Figuren 1 bis 5 erläuterten Ausführungsbeispiele ist, dass die Haltevorrichtung 22 auf Seite der Reflektorschräge 222 deutlich breiter ausgebildet ist als auf der gegenüber liegenden Seite. Dadurch kann die Reflektorschräge 222 statt durch Einprägen beispielsweise auch durch Materialabtragung der Haltevorrichtung 22 in diese eingebracht werden.

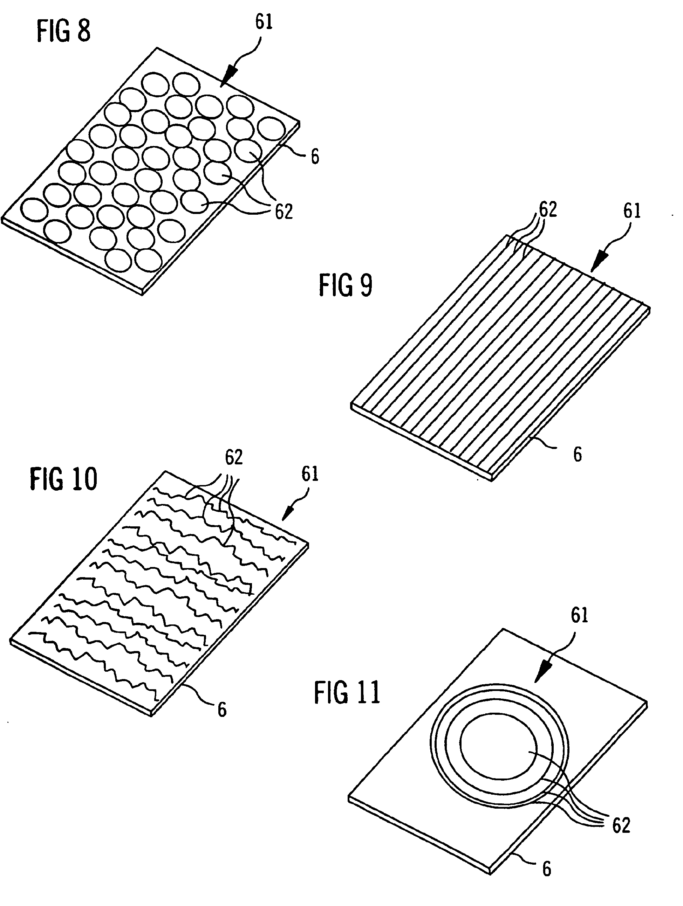

In den Figuren 8 bis 11 sind verschiedene Ausführungsbeispiele von Abdeckplatten 6 mit unterschiedlichen optischen Elementen 61 dargestellt. Die optischen Elemente wiesen jeweils eine Mehrzahl von Strukturelementen 62 auf.

Bei dem in Figur 8 dargestellten Ausführungsbeispiel handelt es sich bei den Strukturelementen 62 um eine Vielzahl von Mikrolinsen. Diese sind unregelmäßig angeordnet, können alternativ jedoch auch regelmäßig angeordnet sein.

Das in Figur 9 enthaltene optische Elemente 61 weist eine Vielzahl optischer Linienstrukturen auf, die durch die dargstellten Linien angedeutet sind. Bei den Linienstrukturen kann es sich beispielsweise um Strukturen in der Art von Zylinderlinsen handeln.

Das in Figur 10 enthaltene optische Element 61 weist Strukturelemente 62 in Form einer Aufrauung auf. Die Größe und Tiefe der Aufrauung ist groß genug, dass eine zu emittierende Laserstrahlung an ihr gestreut wird. Dadurch kann eine Homogenisierung eines zu emittierenden Laserstrahles erzielt werden.

Das in Figur 11 enthaltene optische Element 61 weist Strukturelemente 62 für eine Fresnell-Linse auf.

Die Strukturelemente können jeweils sowohl auf einer Lichteingangsseite als auch auf einer Lichtausgangsseite der Abdeckplatte 6 angeordnet sein. Sie können insbesondere auch auf beiden Seiten enthalten sein, wobei die Strukturelemente auf beiden Seiten gleichartig oder unterschiedlich beschaffen sein können.

Zudem sind Kombinationen der dargestellten Strukturelemente möglich. Beispielsweise können die in den Figuren 8, 9 und 11 dargestellten Strukturelemente jeweils mit einer Aufrauung überlagert werden, wie sie in Figur 10 schematisch dargestellt ist. Zudem können z.B. die Strukturen in der Art wie für eine Fresnell-Linse statt kreisförmig auch linienförmig oder in einer sonstigen Form ausgebildet sein. Die optischen Elemente sind insbesondere dazu geeignet, ein zu emittierendes Laserstrahlenbündel zu homogenisieren.

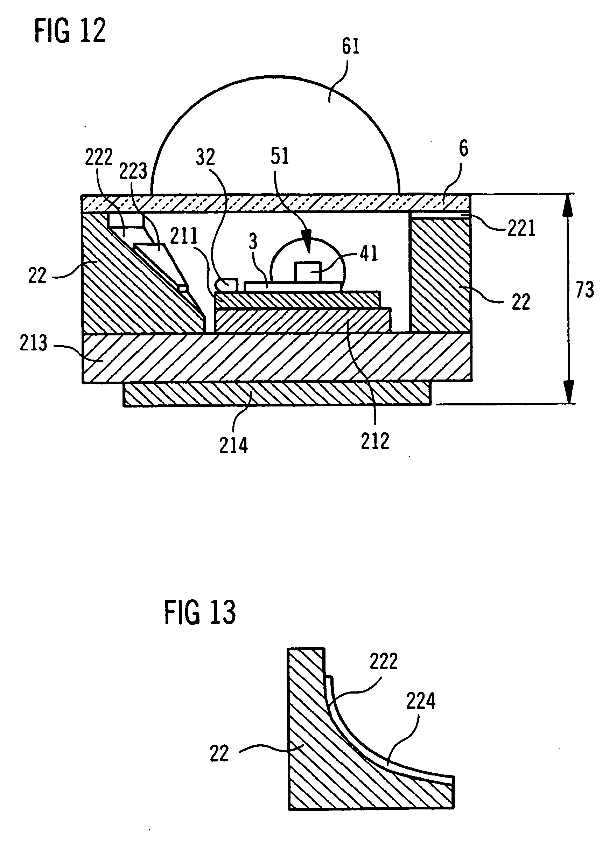

Bei dem in Figur 12 dargestellten Laserdiodenbauelement ist im Unterschied zu dem vorhergehend anhand der Figuren 3 bis 5 beschriebenen Ausführungsbeispiel eine Optik 32 auf der ersten Trägerschicht 211 angeordnet. Die Optik ist beispielsweise eine Zylinderlinse, die auf der ersten Trägerschicht 211 aufgeklebt ist. Für die Verwendung einer derartigen Optik ist der spezielle mehrschichtige Aufbau des Trägers nicht zwingend erforderlich, obgleich er auch hierfür von Vorteil sein kann. Die Optik 32 ist im Strahlengang des Laserdiodenchips oder Laserdiodenbarrens 3 angeordnet.

Auf der Reflektorschräge 222 ist bei dem in Figur 12 dargestellten Laserdiodenbauelement ein Reflektorplättchen 223 aufgebracht. Dieses weist beispielsweise ein Glasplättchen auf, das mit einem Bragg-Spiegel versehen ist. Der Bragg-Spiegel weist eine dielektrische Schichtenfolge auf, die alternierend dielektrische Schichten mit unterschiedlichen Brechungskoeffizienten aufweist. Beispielsweise sind sechs Schichtfolgen mit jeweils einer Schicht aus Silizium und einer Schicht aus Aluminiumoxid enthalten. Die Schichten weisen eine Dicke auf, die einem Viertel oder der Hälfte einer Wellenlänge der zu reflektierenden elektromagnetischen Strahlung entspricht. Statt ein derartiges Reflektorplättchen 223 zu verwenden, ist es grundsätzlich auch möglich, die Reflektorschräge unmittelbar mit einem derartigen Bragg-Spiegel zu versehen.

Ein Beispiel für eine derartige, unmittelbar mit einem Bragg-Spiegel versehene Reflektorschräge 222 ist in dem in Figur 13 dargestellten Ausschnitt eines Halteelements 22 enthalten. Die Reflektorschräge weist eine konkave Wölbung auf und ist mit einem reflektierenden Material 224 versehen. Dies kann beispielsweise eine dielektrische Schichtenfolge für einen Bragg-Spiegel oder aber auch ein reflektierendes metallisches Material sein. Zudem kann das reflektierende Material 224 eine Kombination aus einer reflektierenden Schicht mit einem metallischen Material und einer dielektrischen Schichtenfolge für einen Bragg-Spiegel aufweisen.

Bei dem in Figur 12 veranschaulichten Ausführungsbeispiel ist beispielsweise auch in der Abdeckplatte 6 ein Bragg-Spiegel enthalten. Dieser kann z.B. wie der vorhergehend beschriebene Bragg-Spiegel für die Reflektorschräge ausgebildet sein. Mit dem Bragg-Spiegel kann elektromagnetische Strahlung eines gewünschten, engen Frequenzbereichs selektiv reflektiert werden. Der Bragg-Spiegel kann einen externen Resonatorspiegel für den Laserdiodenchip oder Laserdiodenbarren bilden, mittels dem ein gewünschter zu emittierender Frequenzbereich des Laserdiodenchips eingestellt werden kann. Durch einen derartigen externen Resonatorspiegel können zum Beispiel Temperatureinflüsse auf das Laserdiodenbauelement zumindest teilweise kompensiert werden.

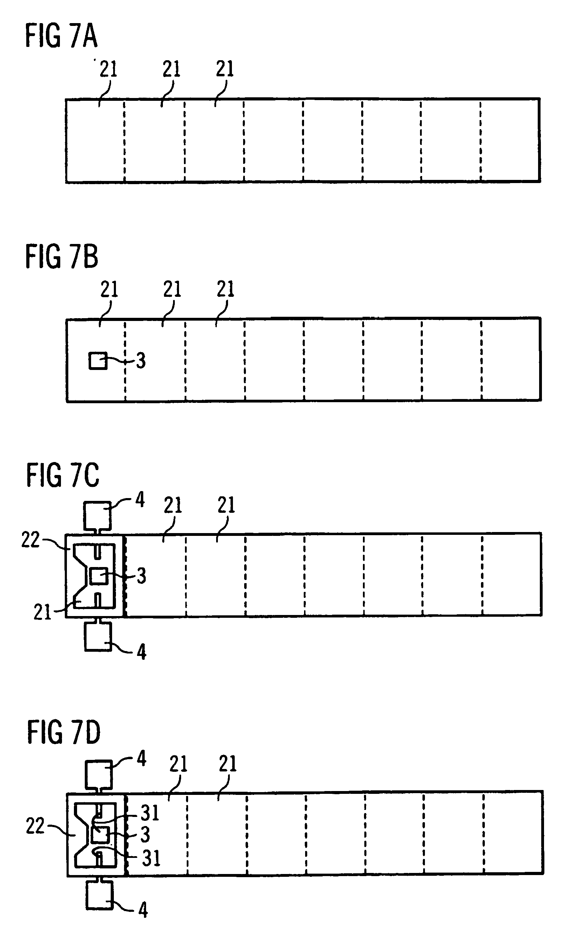

In Figur 7a sind eine Mehrzahl von Trägern 21 für ein Gehäuse dargestellt, die sich in einem gemeinsamen Verbund befinden. In diesem Verbund sind die Träger 21 streifenartig hintereinander oder nebeneinander angeordnet.

Nach Bereitstellen eines derartigen Trägerverbundes wird gemäß eines Ausführungsbeispiels für das Verfahren mindestens ein Laserdiodenchip oder Laserdiodenbarren 3 auf dem Träger 21 elektrisch und mechanisch montiert, was beispielhaft für lediglich einen einzigen Träger 21 des Trägerverbundes in Figur 7b dargestellt ist. Die Laserdiode wird zum Beispiel mittels Löten montiert.

Nach Montage der Laserdiode 3 wird eine Haltevorrichtung 22 auf dem Träger 21 aufgebracht, siehe Figur 7c. Die Haltevorrichtung 22 ist rahmenartig ausgebildet. In ihr oder an ihr sind zwei elektrische Anschlussleiter 4 gehalten. Die Haltevorrichtung 22 sowie die Anschlussleiter 4 können wie in den vorhergehend beschriebenen Ausführungsbeispielen ausgeführt sein.

In einem weiteren Verfahrensschritt werden die elektrischen Anschlussleiter 4 elektrisch leitend mit den Anschlussseiten des Laserdiodenchips oder Laserdiodenbarrens 3 elektrisch leitend verbunden, was beispielsweise durch Bonden mittels Bonddrähten 31 erfolgt, siehe Figur 7d. Nachfolgend kann beispielsweise eine Abdeckplatte auf der Haltevorrichtung 22 aufgebracht werden. Nach Aufbringen der Haltevorrichtung 22 werden die Träger 21 durch einen geeigneten Vereinzelungsprozess voneinander getrennt. Dies kann beispielsweise durch Sägen erfolgen.

Ähnlich wie die Träger 21 können auch mehrere Haltevorrichtung 22 in einem gemeinsamen Verbund bereitgestellt und gemeinsam auf den Trägerverbund aufgebracht werden sowie gemeinsam mit dem Trägerverbund vereinzelt werden.

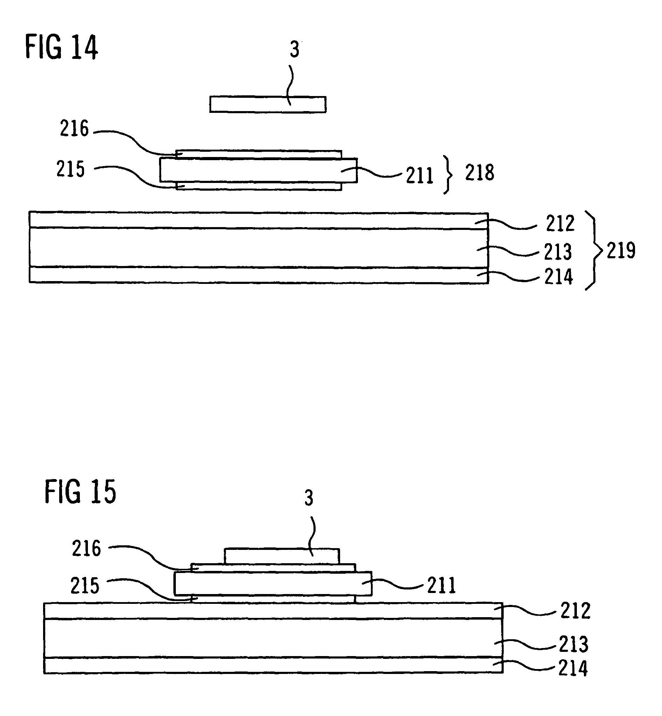

Bei dem in den Figuren 14 und 15 veranschaulichten Ausführungsbeispiel des Verfahrens werden ein erster Teil 218 und ein zweiter Teil 219 eines Trägers 21 bereitgestellt. Der zweite Teil 219 kann sich insbesondere in einem Verbund mit einer Mehrzahl weiterer zweiter Teile 219 für einen Träger befinden. In diesem Fall ist es zweckmäßig, eine entsprechende Zahl separater erster Teile 218 bereitzustellen, um eine Mehrzahl von Laserdiodenbauelemente im Wesentlichen gleichzeitig herzustellen.

Der erste Teil 218 ist auf einer ersten Seite mit einer ersten Hartlotschicht 215 und auf einer der ersten Seite gegenüberliegenden zweiten Seite mit einer zweiten Hartlotschicht 216 versehen. Das Hartlot der Hartlotschichten 215, 216 weist bevorzugt eine Gold-Zinn-Legierung auf. Die Hartlotschichten 215, 216 haben beispielsweise eine Dicke von 2 µm.

Bei dem Verfahren wird zudem ein Laserdiodenchip oder Laserdiodenbarren bereitgestellt.

In einem weiteren Verfahrensschritt werden der Laserdiodenchip oder Laserdiodenbarren 3, der erste Trägerteil 218 und der zweite Trägerteil 219 mittels "Stack-Löten" miteinander verbunden. Dazu wird der erste Teil 218 mit der ersten Hartlotschicht 215 auf den zweiten Teil 219 aufgebracht und der Laserdiodenchip oder Laserdiodenbarren 3 auf die zweite Hartlotschicht 216 aufgebracht. Nachfolgend werden die zuvor losen Teile mittels Wärmezufuhr zusammengelötet. Hierzu wird die Temperatur auf beispielsweise etwa 330 °C erhöht.

Der zweite Teil 219 des Trägers weist eine zweite Trägerschicht 212, eine dritte Trägerschicht 213 und eine vierte Trägerschicht 214 auf. Die zweite 212 und die vierte Trägerschicht 214 bestehen aus einem metallischen Material, beispielsweise aus Kupfer. Die zwischen diesen Schichten angeordnete dritte Trägerschicht 213 weist ein keramisches Material auf, beispielsweise besteht sie aus Aluminiumnitrid. Die mittlere Schicht des zweiten Teils des Trägers 219, das heißt die dritte Trägerschicht 213 mit dem keramischen Material weist einen signifikant geringeren Ausdehnungskoeffizienten auf als die angrenzenden Trägerschichten 212, 214.

Die drei Trägerschichten sind fest miteinander verbunden, so dass sich der niedrige Ausdehnungskoeffizient der dritten Trägerschicht 213 auf die angrenzenden metallischen Trägerschichten 212, 214 zumindest teilweise überträgt. Dadurch wird das Risiko, dass die Hartlotschicht 215 bricht, signifikant verringert. Mittels Hartlöten ist eine besonders gute thermische Anbindung der zu verbindenden Teile möglich. Dagegen ist Hartlöten zum Verbinden eines Teils auf Metall in der Regel nicht üblich, da das Hartlot hier aufgrund der hohen Ausdehnungskoeffizienten von Metallen zu brechen droht. Stattdessen werden derartige Verbindungen bislang unter Verwendung eines Weichlots realisiert.

Alternativ zu dem beschriebenen Ausführungsbeispiel des Verfahrens ist es auch möglich, den ersten Teil 218 des Trägers wegzulassen und den Laserdiodenchip oder Laserdiodenbarren 3 unmittelbar mittels Hartlöten mit dem zweiten Teil 219 des Trägers zu verbinden.

## Patentansprüche

1. Gehäuse (2) für ein Laserdiodenbauelement (1), das für eine Oberflächenmontage ausgeführt ist und einen Träger (21) umfasst, der auf einer Vorderseite einen Montagebereich für einen Laserdiodenchip oder Laserdiodenbarren (3) aufweist,
**dadurch gekennzeichnet, dass**
das Gehäuse (2) mindestens eine auf dem Träger (21) angeordnete Haltevorrichtung (22) umfasst, die
- mindestens einen Durchbruch (5) aufweist, in dem ein elektrischer Anschlussleiter (4) gehalten ist, wobei ein Chipanschlussteil (41) des Anschlussleiters (4) vom Träger (21) beabstandet ist und frei über die Vorderseite des Trägers (21) ragt,
- ein metallisches und/oder keramisches Material aufweist,
- eine Reflektorschräge (222) aufweist, die schräg zu einer Haupterstreckungsebene des Trägers (21) verläuft, und
- als ein Rahmen für das Gehäuse (2) ausgebildet ist.

2. Gehäuse (2) nach Anspruch 1,
wobei ein Bauelementanschlussteil (42) des elektrischen Anschlussleiters (4) lateral vom Träger beabstandet ist.

3. Gehäuse (2) nach einem der vorhergehenden Ansprüche,
wobei der Träger (21) als Wärmeabfuhrelement ausgebildet ist und auf einer der Vorderseite gegenüberliegenden Rückseite eine thermische Anschlussfläche aufweist.

4. Gehäuse (2) nach Anspruch 3,
wobei die thermische Anschlussfläche gegenüber elektrischen Anschlussleitern des Gehäuses (2) elektrisch isoliert ist.

5. Gehäuse (2) nach einem der vorhergehenden Ansprüche,
wobei der Träger (21) keramisches und/oder metallisches Material aufweist.

6. Gehäuse (2) nach einem der vorhergehenden Ansprüche,
wobei der elektrische Anschlussleiter (4) mittels eines Füllmaterials (51) in dem Durchbruch (5) gehalten ist.

7. Gehäuse (2) nach einem der vorhergehenden Ansprüche,
wobei der elektrische Anschlussleiter (4) in den Durchbruch (5) gesteckt ist.

8. Gehäuse (2) nach Anspruch 6,
wobei das Füllmaterial (51) elektrisch isolierend ist.

9. Gehäuse (2) nach einem der vorhergehenden Ansprüche,
wobei der elektrische Anschlussleiter (4) einen breiten Teil (42) und einen schmalen Teil (41) umfasst, wobei der schmale Teil (41) eine geringere Breite als der breite Teil (42) aufweist und derart in dem Durchbruch (5) gehalten ist, dass der breite Teil (42) an der Außenseite der Haltevorrichtung (22) angeordnet ist.

10. Gehäuse (2) nach einem der vorhergehenden Ansprüche,
wobei die Haltevorrichtung (22) im wesentlichen aus metallischem Material besteht.

11. Gehäuse (2) nach einem der vorhergehenden Ansprüche,
wobei die Haltevorrichtung (22) mindestens eines der Materialien Nickel, Eisen und Kobalt oder eine Legierung mit mindestens zwei dieser Materialien aufweist.

12. Gehäuse (2) nach einem der vorhergehenden Ansprüche,
wobei die Haltevorrichtung (22) und der Träger (21) separate Teile sind.

13. Gehäuse (2) nach einem der vorhergehenden Ansprüche,
wobei mindestens zwei elektrische Anschlussleiter (4) jeweils in einem Durchbruch (5) der mindestens einen Haltevorrichtung (22) gehalten sind.

14. Gehäuse (2) nach einem der vorhergehenden Ansprüche,
wobei die Haltevorrichtung (22) mit einer Beschichtung versehen ist, die geeignet ist, elektromagnetische Strahlung zu reflektieren.

15. Gehäuse (2) nach Anspruch 14,
wobei die Beschichtung metallisches Material umfasst oder aus metallischem Material besteht.

16. Gehäuse (2) nach Anspruch 14, wobei die Beschichtung eine Schichtenfolge für einen Bragg-Spiegel aufweist.

17. Gehäuse (2) nach einem der vorhergehenden Ansprüche,
wobei der Rahmen einen Lüftungsdurchbruch (221) aufweist.

18. Gehäuse (2) nach einem der vorhergehenden Ansprüche,
wobei die Reflektorschräge (222) in die Haltevorrichtung (22) eingeprägt ist.

19. Gehäuse (2) nach einem der vorhergehenden Ansprüche,
wobei auf der Reflektorschräge (222) ein Reflektorplättchen (223) angeordnet ist.

20. Gehäuse (2) nach einem der Ansprüche 1 bis 18, wobei die Reflektorschräge (222) eine konkave Krümmung aufweist.

21. Gehäuse (2) nach einem der vorhergehenden Ansprüche,
wobei das Gehäuse (2) für ein Laserdiodenbauelement (1) mit einer Verlustleistung von größer als oder gleich 3 Watt, bevorzugt von größer als oder gleich 5 Watt geeignet ist.

22. Gehäuse (2) nach einem der vorhergehenden Ansprüche,
wobei das Gehäuse (2) für ein Laserdiodenbauelement (1) mit einer Verlustleistung von größer als oder gleich 6 Watt geeignet ist.

23. Laserdiodenbauelement (1) mit einem Gehäuse (2) gemäß einem der vorhergehenden Ansprüche, das mindestens einen Laserdiodenchip oder Laserdiodenbarren (3) aufweist.

24. Laserdiodenbauelement (1) nach Anspruch 23,
wobei der Laserdiodenchip oder der Laserdiodenbrren (3) als Kantenemitter ausgebildet ist.

25. Laserdiodenbauelement (1) nach Anspruch 23 oder 24,
das eine Verlustleistung von größer als oder gleich 3 Watt, bevorzugt von größer als oder gleich 5 Watt aufweist.

26. Laserdiodenbauelement (1) nach Anspruch 23 oder 24,
das eine Verlustleistung von größer als oder gleich 6 Watt aufweist.

27. Laserdiodenbauelement nach einem der Ansprüche 23 bis 25,
wobei auf der Haltevorrichtung (22) ein Abdeckkörper (6) aufgebracht ist.

28. Laserdiodenbauelement nach einem der Ansprüche 23 bis 27,
wobei auf dem Träger (21) und in einem Strahlengang des Laserdiodenchips oder Laserdiodenbarrens (3) eine Optik (61) angeordnet ist.

## Claims

1. A housing (2) for a laser diode component (1), which is configured for surface mounting and includes a carrier (21), which comprises a mounting region on the front for a laser diode chip or laser diode bar (3), **characterised in that** the housing (2) includes at least one holding device (22) arranged on the carrier (21), which
- comprises at least one aperture (5), in which an electrical terminal conductor (4) is held, a chip connection part (41) of the terminal conductor (4) being spaced from the carrier (21) and projecting freely over the front of the carrier (21),
- comprises a metallic and/or ceramic material,
- comprises a reflector bevel (222), which runs obliquely to a main plane of extension of the carrier (21), and
- is formed as a frame for the housing (2).

2. The housing (2) according to claim 1,
wherein a component connection part (42) of the electrical terminal conductor (4) is spaced laterally from the carrier.

3. The housing (2) according to either one of the preceding claims, wherein the carrier (21) is formed as a heat dissipating element and comprises a thermal connection area on a rear side opposite the front.

4. The housing (2) according to claim 3,
wherein the thermal connection area is electrically insulated from electrical terminal conductors of the housing (2).

5. The housing (2) according to any one of the preceding claims,
wherein the carrier (21) comprises ceramic and/or metallic material.

6. The housing (2) according to any one of the preceding claims, wherein the electrical terminal conductor (4) is held in the aperture (5) by means of a filling material (51).

7. The housing (2) according to any one of the preceding claims, wherein the electrical terminal conductor (4) is inserted in the aperture (5).

8. The housing (2) according to claim 6, wherein the filling material (51) is electrically insulating.

9. The housing (2) according to any one of the preceding claims, wherein the electrical terminal conductor (4) includes a wide part (42) and a narrow part (41), wherein the narrow part (41) has a smaller width than the wide part (42) and is held in the aperture (5) in such a way that the wide part (42) is arranged on the outside of the holding device (22).

10. The housing (2) according to any one of the preceding claims, wherein the holding device (22) consists substantially of metallic material.

11. The housing (2) according to any one of the preceding claims, wherein the holding device (22) comprises at least one of the materials nickel, iron and cobalt or an alloy including at least two of these materials.

12. The housing (2) according to any one of the preceding claims,
wherein the holding device (22) and the carrier (21) are separate parts.

13. The housing (2) according to any one of the preceding claims, wherein at least two electrical terminal conductors (4) are held in each case in an aperture (5) of the at least one holding device (22).

14. The housing (2) according to any one of the preceding claims, wherein the holding device (22) is provided with a coating, which is suitable for reflecting electromagnetic radiation.

15. The housing (2) according to claim 14,
wherein the coating includes metallic material or consists of metallic material.

16. The housing (2) according to claim 14, wherein the coating comprises a layer sequence for a Bragg mirror.

17. The housing (2) according to any one of the preceding claims, wherein the frame comprises a ventilation aperture (221).

18. The housing (2) according to any one of the preceding claims, wherein the reflector bevel (222) is impressed in the holding device (22).

19. The housing (2) according to any one of the preceding claims, wherein a reflector plate (223) is arranged on the reflector bevel (222).

20. The housing (2) according to any one of claims 1 to 18, wherein the reflector bevel (222) has a concave curvature.

21. The housing (2) according to any one of the preceding claims, wherein the housing (2) is suitable for a laser diode component (1) with a power loss of greater than or equal to 3 watts, preferably of greater than or equal to 5 watts.

22. The housing (2) according to any one of the preceding claims, wherein the housing (2) is suitable for a laser diode component (1) with a power loss of greater than or equal to 6 watts.

23. A laser diode component (1) with a housing (2) according to any one of the preceding claims, which comprises at least one laser diode chip or laser diode bar (3).

24. The laser diode component (1) according to claim 23, wherein the laser diode chip or the laser diode bar (3) is formed as an edge emitter.

25. The laser diode component (1) according to claim 23 or claim 24, which has a power loss of greater than or equal to 3 watts, preferably of greater than or equal to 5 watts.

26. The laser diode component (1) according to claim 23 or claim 24, which has a power loss of greater than or equal to 6 watts.

27. The laser diode component according to any one of claims 23 to 25, wherein a cover body (6) is placed on the holding device (22).

28. The laser diode component according to any one of claims 23 to 27, wherein an optical system (61) is arranged on the carrier (21) and in a beam path of the laser diode chip or laser diode bar (3).

## Revendications

1. Boîtier (2) pour un composant à diode laser (1), qui est réalisé pour un montage en surface et comprend un support (21) présentant sur une face avant une zone de montage pour une puce à diode laser ou une barre à diode laser (3),
**caractérisé en ce que**
le boîtier (2) comprend au moins un dispositif de maintien (22) disposé sur le support (21), lequel dispositif
- présente au moins une aperture (5) dans laquelle est maintenu un conducteur de connexion électrique (4), une pièce de connexion de puce (41) du conducteur de connexion(4) étant distancée du support (21) et dépassant librement au-dessus de la face avant du support (21),
- présente une matière métallique et/ou céramique,
- présente une inclinaison de réflexion (222) qui s'étend de manière oblique par rapport à un plan principal d'étendue du support (21), et
- est réalisé en tant qu'un cadre pour le boîtier (2).

2. Boîtier (2) selon la revendication 1,
une pièce de connexion de composant (42) du conducteur de connexion électrique (4) étant distancée du support latéralement.

3. Boîtier (2) selon l'une quelconque des revendications précédentes,
le support (21) étant réalisé en tant qu'élément de dissipation de chaleur et présentant une surface de connexion thermique sur une face arrière opposée à la face avant.

4. Boîtier (2) selon la revendication 3,
la surface de connexion thermique étant isolée électriquement par rapport aux conducteurs de connexion électriques du boîtier (2).

5. Boîtier (2) selon l'une quelconque des revendications précédentes,
le support (21) présentant une matière céramique et/ou métallique.

6. Boîtier (2) selon l'une quelconque des revendications précédentes,
le conducteur de connexion électrique (4) étant maintenu dans l'aperture (5) au moyen d'une matière de remplissage (51).

7. Boîtier (2) selon l'une quelconque des revendications précédentes,
le conducteur de connexion électrique (4) étant emboîté dans l'aperture (5).

8. Boîtier (2) selon la revendication 6,
la matière de remplissage (51) étant électriquement isolante.

9. Boîtier (2) selon l'une quelconque des revendications précédentes,
le conducteur de connexion électrique (4) comprenant une partie large (42) et une partie étroite (41), la partie étroite (41) présentant une largeur plus petite que la partie large (42) et étant maintenue dans l'aperture (5) de manière à ce que la partie large (42) soit disposée sur le côté extérieur du dispositif de maintien (22).

10. Boîtier (2) selon l'une quelconque des revendications précédentes,
le dispositif de maintien (22) étant essentiellement constitué de matière métallique.

11. Boîtier (2) selon l'une quelconque des revendications précédentes,
le dispositif de maintien (22) présentant au moins l'une des matières nickel, fer et cobalt ou un alliage comprenant au moins deux de ces matières.

12. Boîtier (2) selon l'une quelconque des revendications précédentes,
le dispositif de maintien (22) et le support (21) étant des pièces séparées.

13. Boîtier (2) selon l'une quelconque des revendications précédentes,
au moins deux conducteurs de connexion électriques (4) étant respectivement maintenus dans une aperture (5) de l'au moins un dispositif de maintien (22).

14. Boîtier (2) selon l'une quelconque des revendications précédentes,
le dispositif de maintien (22) étant muni d'un revêtement qui est apte à réfléchir le rayonnement électromagnétique.

15. Boîtier (2) selon la revendication 14,
le revêtement comprenant une matière métallique ou étant constitué d'une matière métallique.

16. Boîtier (2) selon la revendication 14,
le revêtement présentant une succession de couches pour un miroir de Bragg.

17. Boîtier (2) selon l'une quelconque des revendications précédentes,
le cadre présentant une aperture de ventilation (221).

18. Boîtier (2) selon l'une quelconque des revendications précédentes,
l'inclinaison de réflexion (222) étant empreinte dans le dispositif de maintien (22).

19. Boîtier (2) selon l'une quelconque des revendications précédentes,
une plaquette de réflexion (223) étant disposée sur l'inclinaison de réflexion (222).

20. Boîtier (2) selon l'une quelconque des revendications 1 à 18, l'inclinaison de réflexion (222) présentant une courbure concave.

21. Boîtier (2) selon l'une quelconque des revendications précédentes,
le boîtier (2) convenant pour un composant à diode laser (1) ayant une puissance dissipée supérieure ou égale à 3 watts, de préférence supérieure ou égale à 5 watts.

22. Boîtier (2) selon l'une quelconque des revendications précédentes,
le boîtier (2) convenant pour un composant à diode laser (1) ayant une puissance dissipée supérieure ou égale à 6 watts.

23. Composant à diode laser (1) comprenant un boîtier (2) selon l'une quelconque des revendications précédentes, qui présente au moins une puce à diode laser ou une barre à diode laser (3).

24. Composant à diode laser (1) selon la revendication 23, la puce à diode laser ou la barre à diode laser (3) étant réalisée en tant qu'émetteur à effet de bord.

25. Composant à diode laser (1) selon la revendication 23 ou 24, lequel présente une puissance dissipée supérieure ou égale à 3 watts, de préférence supérieure ou égale à 5 watts.

26. Composant à diode laser (1) selon la revendication 23 ou 24, lequel présente une puissance dissipée supérieure ou égale à 6 watts.

27. Composant à diode laser selon l'une quelconque des revendications 23 à 25, un corps de recouvrement (6) étant appliqué sur le dispositif de maintien (22).

28. Composant à diode laser selon l'une quelconque des revendications 23 à 27, une optique (61) étant disposée sur le support (21) et dans une trajectoire de faisceau de la puce à diode laser ou de la barre à diode laser (3).
